# EUROPÄISCHE PATENTSCHRIFT

(11) **EP 1 173 859 B1**
(45) Veröffentlichungstag und Bekanntmachung des Hinweises auf die Patenterteilung: **01.10.2003**
(21) Anmeldenummer: 00929283.0
(22) Anmeldetag: 07.04.2000
(51) Int. Cl.: H01G 2/08, H01G 2/02

(54) **LEISTUNGSELEKTRONIK-BAULEMENT MIT VERBESSERTEN THERMISCHEN EIGENSCHAFTEN**
POWER ELECTRONICS COMPONENT WITH IMPROVED THERMAL PROPERTIES
COMPOSANT ELECTRONIQUE DE PUISSANCE PRESENTANT DES PROPRIETES THERMIQUES AMELIOREES

(30) Priorität: 21.04.1999 DE 19918090
(43) Veröffentlichungstag der Anmeldung: 23.01.2002
(73) Patentinhaber: EPCOS AG, 81669 München (DE)
(72) Erfinder: VETTER, Harald, D-89520 Heidenheim (DE)
(74) Vertreter: Epping Hermann & Fischer
(86) Internationale Anmeldenummer: DE0001081
(87) Internationale Veröffentlichungsnummer: WO00065615

(56) Entgegenhaltungen:
- US-A- 4 760 494
- US-A- 4 893 217

## Beschreibung

Die vorliegende Erfindung betrifft ein Leistungselektronik-Bauelement mit einem elektrisch aktiven Bereich und einem von diesem durch einen Spalt beabstandeten Gehäuse, vgl, z.B. US-A-4 760 494.

Bei Leistungselektronik-Bauelementen, wie beispielsweise Leistungskondensatoren, Phasenbausteinen zur Niederspannungs-Blindstromkompensation oder ähnlichen Bauteilen ist eine zuverlässige Wärmeabfuhr von großer Bedeutung. Mit anderen Worten, solche Bauelemente sollten sich durch einen niedrigen Wärmewiderstand auszeichnen.

Nun gibt es trockene, gasimprägnierte Bauelemente sowie mit Öl oder Harz gefüllte Bauelemente. Gasimprägnierte Bauelemente haben einen schlechteren Wärmewiderstand als mit Öl oder Harz gefüllte Bauelemente. Demgegenüber sind aber gasimprägnierte Bauelemente hinsichtlich der Umweltbelastung vorzuziehen: Öl- und Harzfüllungen rufen bekanntlich Umweltprobleme hervor, die besonders dann auftreten, wenn diese entsorgt werden, oder ein Brandfall zu verzeichnen ist.

Speziell bei Leistungskondensatoren wird, wie dies bereits oben erläutert wurde, zwischen sogenannten "nassen Bauformen" mit einer Ölimprägnierung, gegebenenfalls in Zwischenstufen auch einer Semiimprägnierung, und "trockenen Bauformen" mit einer Gasimprägnierung oder einem Verguß mit Materialien wie Epoxydharz, Polyurethanharz oder Rizinusöl mit einem Polyurethan-Härter unterschieden. Diese Materialien können dabei unterschiedliche Viskositäten haben, deren Bereich von hart bis geleeartig reicht.

Alle diese verschiedenen Varianten sind allgemein weit verbreitet und zeichnen sich bei Bau und Betrieb der Leistungskondensatoren jeweils durch ihnen eigene Vorteile und Nachteile aus. So ist beispielsweise zu bedenken, daß ölimprägnierte Bauelemente neben Umweltproblemen auch eine höhere Brandlast haben.

Bei der Entscheidung, ob "nasse Bauformen" oder "trockene Bauformen" zum Einsatz gelangen, sind auch deren Eigenschaften hinsichtlich Entflammbarkeit, Rauchentwicklung, Toxizität zu berücksichtigen. Speziell Vergußmassen werfen in dieser Hinsicht nicht unerhebliche Probleme auf.

Generell läßt sich also feststellen, daß, wie eingangs bereits angedeutet wurde, trockene, gasimprägnierte Leistungskondensatoren den entsprechenden "nassen Bauformen" im Wärmewiderstand partiell unterlegen sind, dafür aber hinsichtlich Umweltbelastungen geringere Probleme aufwerfen. So sind also "trockene Bauformen" mit Gasimprägnierung hinsichtlich der Umweltbelastung im Betrieb und am Ende der Lebensdauer und hinsichtlich eines Brandfalles nassen Bauformen überlegen.

Ein weiterer Vorteil der "trockenen Bauformen" liegt in deren im Vergleich zu den "nassen Bauformen" erheblich geringerem Gewicht.

Es sollen nun aber Bauelemente mit höherer Leistung entwikkelt werden, wie beispielsweise Phasenschieber-Kondensatoren zur Niederspannungsblindstromkompensation mit einer Leistung von etwa 25 kVAr bis 50 kVAr. Ebenso besteht eine Tendenz in Richtung höherer Ströme bei Zwischenkreis- und Saugkreiskondensatoren, die zusammen mit IGBT-Umrichtern (IGBT = Bipolartransistor mit isoliertem Gate) eingesetzt werden. Für alle diese Bauelemente mit höherer Leistung ist ein besserer Wärmewiderstand vorteilhaft.

Bei diesen Überlegungen ist auch noch die Feuchte-Adsorptionsfähigkeit des Einbaus der jeweiligen Bauformen zu berücksichtigen. Denn bei einigen Anwendungen muß mit einer endlichen Feuchtediffusion in das Bauelementgehäuse gerechnet werden, wie beispielsweise bei Vergußvarianten, so daß für einen zuverlässigen Betrieb eine ausreichende Adsorption der Feuchte gegeben sein sollte.

Es ist daher Aufgabe der vorliegenden Erfindung, ein Leistungselektronik-Bauelement zu schaffen, das im Betrieb und bei seiner Entsorgung umweltfreundlich ist, einen hervorragenden Wärmewiderstand hat, Feuchtigkeit zu adsorbieren vermag und sich zusätzlich durch ein geringes Gewicht auszeichnet.

Diese Aufgabe wird bei einem Leistungselektronik-Bauelement gemäß Anspruch 1, wie insbesondere einem Leistungskondensator, mit einem elektrisch aktiven Bereich, wie beispielsweise dem Wickel eines Leistungskondensators, und mit einem von diesem durch einen Spalt beabstandeten Gehäuse erfindungsgemäß dadurch gelöst, daß der Spalt mit einem mineralischen schüttbaren Granulat gefüllt ist.

Bei dem erfindungsgemäßen Leistungselektronik-Bauelement wird also ein mineralisches, schüttbares Granulat als Isoliermaterial beispielsweise im Spalt zwischen einer Wickelhüllwand und einer Gehäuseinnenwand bei einem Leistungskondensator verwendet. Ein solches mineralisches, schüttbares Granulat kann durch eine geeignete Vorbehandlung ohne weiteres in eine Lage versetzt werden, daß es Feuchtigkeit effizient zu adsorbieren vermag. Stoffe, die diese Eigenschaften besitzen, werden auch als "Molekularsiebe" bezeichnet. Solche Molekularsiebe sind beispielsweise synthetisch hergestellte Zeolithe mit kristallinem Gitteraufbau.

Das Granulat wird, worauf bereits hingewiesen wurde, beispielsweise in den Spalt zwischen der Wickelhüllwand und der Gehäuseinnenwand bei einem Leistungskondensator eingefüllt. Durch Rütteln kann es dort ausreichend verdichtet werden.

Auf die Molekularsiebeigenschaft kann gegebenenfalls verzichtet werden, wenn das Leistungselektronik-Bauelement ohnehin nur in trockener Umgebung eingesetzt wird. In diesem Fall kann für das Granulat auf geeignete Werkstoffe mit Körnung zurückgegriffen werden, ohne auf die Feuchteadsorptionsfähigkeit zu achten.

Versuche des Erfinders an großen Phasenschieberkondensatoren haben gezeigt, daß mit einem Granulat als Isolierstoff im Spalt zwischen Wickelhüllwand und Gehäuseinnenwand tatsächlich ohne großen Aufwand die angestrebten guten Wärmeleitungseigenschaften erreicht werden können, so daß im aktiven Bereich der Phasenschieberkondensatoren, also im Wickel, erzeugte Wärme wirksam nach außen abgeführt werden kann. Ein Granulat hat in üblicher Ausführung ein Schüttgewicht von etwa 0,7 kg/dm_ und ist damit erheblich leichter als Öl oder insbesondere Vergußmasse.

Es sei an dieser Stelle darauf hingewiesen, daß mit dem Schüttgewicht das Wärmeleitvermögen des Granulats beeinflußt werden kann. Ist dieses geringer, so ist das Wärmeleitvermögen niedriger als bei einem höheren Schüttgewicht.

Der Kostenaufwand für das Granulat ist äußerst gering und liegt deutlich unter demjenigen für Öl oder für Vergußmasse. Auch ist in diesem Zusammenhang zu bedenken, daß das Granulat auf die für die Wärmeabfuhr entscheidenden Regionen im Bauelement konzentriert werden kann, was für eine Ölimprägnierung oder einen Verguß grundsätzlich nicht gilt.

Messungen an einem 25 kVAr-Rundbecher-Phasenschieberkondensator der MKKAC-Baureihe (MKK = metallisierter Kunststoffkondensator, AC = Wechselstrom) zeigen, daß bei einer Blindleistung von 50 kVAr die sogenannte "hot-spot"-Temperatur (heißeste Stelle im Kondensator) durch Granulatbefüllung des Spalts zwischen Wickelhüllwand und Gehäuseinnenwand im Vergleich zu einer gasimprägnierten Variante um 7° K abgesenkt werden kann. Durch Vergleichsversuche zwischen Leistungskondensatoren mit Gasimprägnierung, Ölimprägnierung, Gießharzimprägnierung und Granulat im Spalt zwischen Wickelhüllwand und Gehäuseinnenwand bzw. im Leistungskondensator insgesamt ergeben für einen Leistungskondensator mit Granulat im Spalt das deutlich beste Ergebnis.

Die erhebliche Reduzierung des Wärmewiderstandes erlaubt eine Weiterentwicklung von Leistungskondensatoren in Richtung auf höhere Leistungen.

Auch beeinflußt die gute Adsorptionsfähigkeit eines Molekularsieb-Granulats die Lebensdauer eines Leistungskondensators in trockener Bauform positiv. Dabei können gegebenenfalls auch die Trocknungsanforderungen beim Prozeß und der Prüfung erheblich reduziert werden, was zu einer Kostenreduzierung bei der Fertigstellung des Leistungskondensators führt. Auch ermöglicht die Feuchteadsorptionsfähigkeit des Molekularsiebgranulats Konstruktionskonzepte mit partieller Kunststoffabdeckung im Anschlußbereich von beispielsweise Rechteck-Großkondensatoren. Kunststoffabdeckungen oder Vergußmassen haben materialbedingt immer eine mehr oder weniger ausgeprägte Feuchtediffusion zu verzeichnen, so daß gegebenenfalls die hieraus bekannten Materialdaten ausgenutzt werden können, um eine Granulatmenge in einem Bauelement so festzulegen, daß das Granulat während der gesamten Lebensdauer des Bauelementes in der Lage ist, die eindiffundierende Feuchtigkeitsmenge zuverlässig aufzunehmen.

Bei dem erfindungsgemäßen Leistungselektronik-Bauelement handelt es sich in bevorzugter Weise um einen Leistungskondensator. Es kann jedoch auch ein anderes Bauelement, wie beispielsweise eine Induktivität oder ein Leistungshalbleiterbauelement sein, bei dem für eine gute Wärmeabführung gesorgt werden muß.

Die mit der Erfindung zu erzielenden Vorteile lassen sich wie folgt zusammenfassen:

Das Granulat wirft keine Umweltprobleme auf, da sein mineralischer Basiswerkstoff auch im Brandfall thermisch stabil ist und so weder eine giftige Wirkung zeigt noch ein Treibhauspotential beinhaltet. Weiterhin ist durch eine ausreichend gewählte Granulatmenge eine reduzierte Dichtheitsanforderung durch gezielte Ausnutzung des Feuchte-Adsorptionseffektes des Granulats denkbar. Gegenüber Öl und Vergußmassen bietet das Granulat einen deutlichen Gewichtsvorteil mit einem Schüttgewicht von etwa 0,7 kg/cm_. Weiterhin kann das Granulat ohne weiteres auf den Spalt zwischen Gehäuse und Wickel konzentriert werden, so daß insoweit der Aufwand für das Granulat reduziert werden kann und Gewicht einzusparen ist. Wird auch das Kernrohr bei einem Leistungskondensator gefüllt, so bedingt dies in der Regel eine höhere Hot-Spot-Temperatur, d.h., der Wärmewiderstand wird ungünstig beeinflußt. Die Vorteile gegenüber Öl oder Verguß werden besonders dann deutlich, wenn das Granulat nur in den Spalt zwischen Wickel und Gehäuse eingebracht wird. Im Vergleich zu einem Vergußmaterial ist für das Einbringen des Granulats keine aufwendige Apparatur erforderlich. Das heißt, auf aufwendige Vergießeinrichtungen kann verzichtet werden. Verarbeitungsprobleme im Zusammenhang mit dem Granulat sind nicht erkennbar. So ist beispielsweise kein Weißraum erforderlich. Weiterhin verdrängt das Granulat einen erheblichen Teil des Restvolumens speziell bei Rechteck-Kondensatoren, so daß hier auch eine Gasimprägnierung mit reinem SF6 möglich wird, was eine deutliche Lebensdauerverlängerung des Kondensators zur Folge hat.

Das erfindungsgemäße Leistungselektronik-Bauelement mit dem mineralischen schüttbaren Granulat im Spalt zwischen einem aktiven Bereich und einem von diesem beabstandeten Gehäuse vereinigt die Vorteile eines gasimprägnierten Bauelements mit demjenigen einer Öl- oder Harzfüllung und hat außerdem eine hervorragende Feuchteadsorptionsfähigkeit.

Nachfolgend wird die Erfindung anhand der Zeichnung näher erläutert. Es zeigen:
- Fig. 1: eine schematische Ansicht eines Wickelkondensators, der nach der vorliegenden Erfindung aufgebaut ist,
- Fig. 2: eine schematische Ansicht eines anderen Wickelkondensators, der nach der vorliegenden Erfindung aufgebaut ist, und
- Fig. 3: ein Diagramm, bei dem der Wärmewiderstand Rₜₕ in Abhängigkeit von der Blindleistung für verschiedene Füllungen eines Kondensators aufgetragen ist.

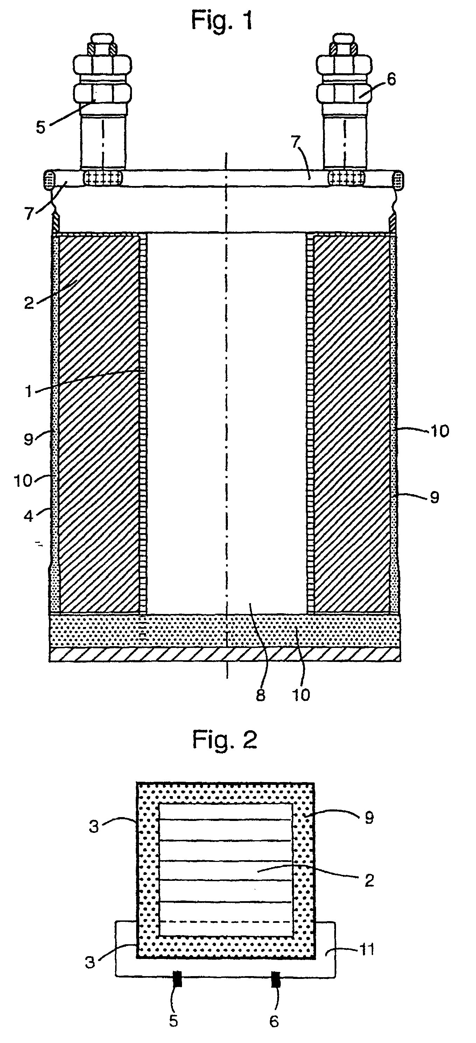

Fig. 1 zeigt einen Wickelkondensator aus einem Kernrohr 1, das von einem oder mehreren Wickeln 2 umgeben ist. Sind mehrere Wickel 2 vorhanden, so sind diese durch eine Trennlage aus Isoliermaterial voneinander getrennt. Für die vorliegende Erfindung ist es selbstverständlich unerheblich, ob der Wikkelkondensator über einen oder mehrere Wickel 2 verfügt. Die Wickel 2 sind wiederum in einem Gehäuseaußenrohr 4 untergebracht, das zylindrisch gestaltet ist, die Wickel 2 sowie das Kernrohr 1 mantelförmig umgibt und an seinen Enden beispielsweise mit kunststoffabdeckplatten versehen sein kann.

Die elektrische Zufuhr zu den Wickeln 2 erfolgt über Anschlüsse 5, 6, die auf der Deckelseite des Wickelkondensators vorgesehen sind und dort elektrisch isoliert in einem Ringflansch 7 festgelegt sind. Dabei führt der elektrische Anschluß 5 beispielsweise zu der Innenseite eines inneren Wikkels, während der elektrische Anschluß 6 an die Innenseite eines äußeren Wickels angeschlossen ist. Die beiden Wickel stehen miteinander an der Bodenseite durch die Schoopschicht in elektrischer Verbindung.

Erfindungsgemäß ist nun bei diesem Wickelkondensator der Spalt 9 (und ggf. auch der Kernrohr-Innenraum 8) zwischen der Außenseite der Wickel 2 (Wickelhüllwand) und der Innenseite des Gehäuseaußenrohres 4 (Gehäuseinnenwand) mit einem Granulat 10 gefüllt, das beispielsweise durch Rütteln ausreichend verdichtet ist und auch den Bodenbereich zwischen Gehäuseinnenwand und Wickel ausfüllt. Dieses Granulat kann gegebenenfalls auch Molekularsiebeigenschaft aufweisen, wenn auf Feuchteadsorption besonderer Wert gelegt wird. Als Granulat sind beispielsweise synthetisch hergestellte Zeolithe mit kristallinem Gitteraufbau verwendbar. Alternativ sind Quarzsande oder ähnliches geeignet, wenn auf die Adsorptionsfähigkeit verzichtet werden kann.

Bei dem Ausführungsbeispiel von Fig. 2 ist der gesamte Spalt 9 zwischen dem Wickel 2 und einem Gehäuse 3 mit dem Granulat 10 gefüllt. Hier kann das Gehäuse 3 auf eine Plattform 11 mit Anschlüssen 5, 6 sitzen.

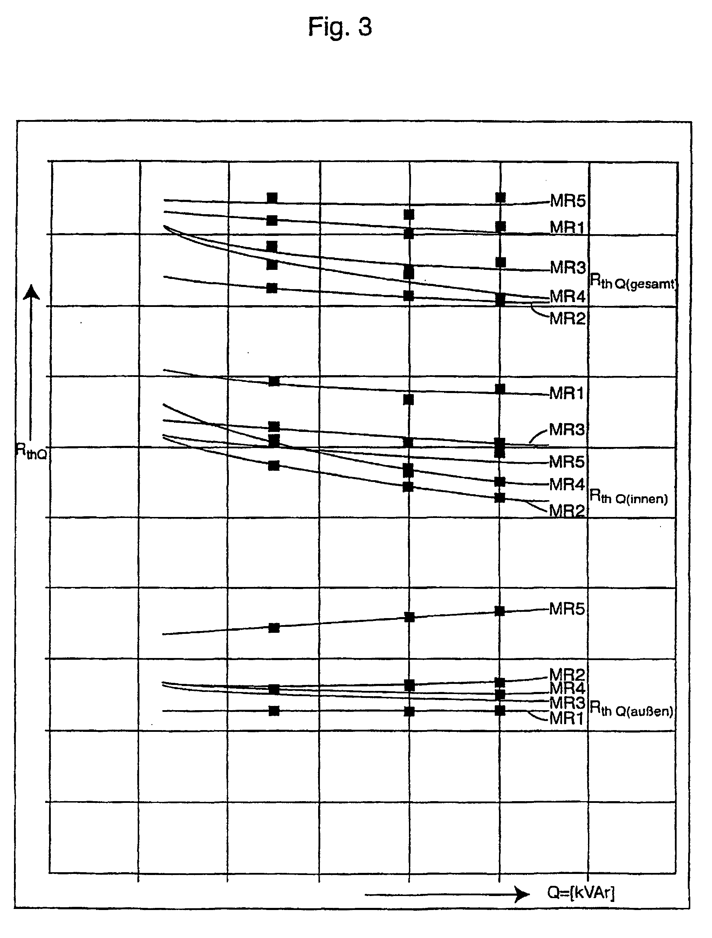

Das Granulat 10 hat beispielsweise ein Schüttgewicht von etwa 0,7 kg/dm_ und ist damit deutlich leichter als Öl oder Vergußmasse, so daß der Wickelkondensator mit geringerem Gewicht hergestellt werden kann. Das Wärmeleitvermögen des Granulates ist demjenigen von Gas deutlich überlegen, wie dies im folgenden anhand der Fig. 3 erläutert werden wird.

In Fig. 3 ist auf der Ordinate der transformierte Wärmewiderstand R_{thQ} in °K/kVAr in Abhängigkeit von der Blindleistung Q in kVAr dargestellt. Dabei bedeuten Kurven R_{thQ(Gesamt)} den gesamten Wärmewiderstand zwischen "hot-spot" und Umgebung, R_{thQ(Innen)} den Wärmewiderstand zwischen "hot-spot" und Gehäuseinnenwand und R_{thQ(Außen)} den Wärmewiderstand zwischen Gehäuse und Umgebung. Kurven MR1 geben die Meßergebnisse für einen luftgefüllten Spalt an, während Kurven MR2 Meßergebnisse für Granulat im Spalt zeigen, Kurven MR3 für Meßergebnisse für Granulat in Spalt und Kernrohr 1 stehen, Kurven MR4 Meßergebnisse für einen ölimprägnierten Wickelkondensator darstellen und Kurven MR5 Meßergebnisse für einen Wickelkondensator mit Vergußfüllung widerspiegeln.

Es ist zu ersehen, daß die Kurven MR2 insgesamt den niedrigsten Wärmewiderstand aufweisen. Das heißt, eine Füllung von Granulat im Spalt zwischen Wickelhüllwand und Gehäuseinnenwand ist vorzuziehen.

Versuche an einem 25 kVAr MKK-AC Kondensator mit schwarzer Oberfläche mit verschiedenen Blindleistungen Q und unterschiedlichen Füllmedien (Luft, Molekularsiebgranulat im Spalt zwischen Wickelhüllwand und Gehäuseinnenwand - d.h. Kernrohr nicht gefüllt, Molekularsiebgranulat im gesamten Kondensator verteilt, Ölfüllung und Harzfüllung) durchgeführt. In Tabelle 1 sind die wichtigsten Ergebnisse zusammengefaßt:

**Tabelle 1**

| **Füllmedium** | **Q = 25 kVAr ?T**_{**A-hs**} **[K]** | **Relativver- gleich [K]** | **Q = 50 kVAr ?T**_{**A-hs**} **[K]** | **Relativver- gleich [K]** |
|---|---|---|---|---|
| Luft | 22,9 | ?0,0 | 46,1 | ?0,0 |
| Granulat im Spalt | 20,5 | -2,4 | 40,0 | -6,1 |
| Granulat im ges. Kond. | 22,1 | -0,8 | 42,8 | -3,3 |
| Ölfüllung | 21,5 | -1,4 | 40,7 | -5,4 |
| Harzfüllung | 23,7 | +0,8 | 47,5 | +1,4 |

Daraus ergibt sich sofort:
- Die Füllmedien Öl und Molekularsiebgranulat liefern einen günstigeren Wärmewiderstand R_{th_} als Luft.
- Die Harzfüllung ist im Spalt um einen Faktor 2 besser als Luft und damit vergleichbar zur Ölfüllung bzw. zu Molekularsiebgranulat, aber durch die prozeßbedingte vollständige Füllung des Kondensators inkl. Kernrohr mit Harz ergibt sich für Rth insgesamt kein Vorteil.
- Die besten Ergebnisse werden mit dem Molekularsiebgranulat im Spalt zwischen Wickelhüllwand und Gehäuseinnenwand
- d.h. Kernrohr nicht gefüllt - erzielt.

## Patentansprüche

1. Leistungselektronik-Bauelement mit einem elektrisch aktiven Bereich, der in einem Gehäuse (4) angeordnet ist,
**dadurch gekennzeichnet, daß**
ein Spalt (9) zwischen der Außenseite des elektrisch aktiven Bereiches und der Innenseite des Gehäuses (4) mit einem mineralischen schüttbaren Granulat (10) gefüllt ist.

2. Leistungselektronik-Bauelement nach Anspruch 1,
**dadurch gekennzeichnet, daß**
das Granulat (10) ein Molekularsiebgranulat ist.

3. Leistungselektronik-Bauelement nach Anspruch 2,
**dadurch gekennzeichnet, daß**
das Molekularsiebgranulat aus Zeolithen mit kristallinem Gitteraufbau besteht.

4. Leistungselektronik-Bauelement nach einem der Ansprüche 1 bis 3,
**dadurch gekennzeichnet, daß**
das Granulat ein Schüttgewicht von etwa 0,7 kg/dm³ aufweist.

5. Leistungselektronik-Bauelement nach einem der Ansprüche 1 bis 4,
**dadurch gekennzeichnet, daß**
das Granulat (10) feuchteadsorbierend ist.

6. Leistungselektronik-Bauelement nach einem der Ansprüche 1 bis 5,
**dadurch gekennzeichnet, daß**
das Gehäuse (4) mit Kunststoffabdeckplatten versehen ist.

7. Leistungselektronik-Bauelement nach einem der Ansprüche 1 bis 6,
**dadurch gekennzeichnet, daß**
es durch einen Leistungskondensator oder einen Phasenbaustein gebildet ist.

## Claims

1. Power electronics component with an electrically active region which is arranged in a housing (4), **characterized in that** a gap (9) between the outside of the electrically active region and the inside of the housing (4) is filled with pourable mineral granules (10).

2. Power electronics component according to Claim 1, **characterized in that** the granules (10) are molecular sieve granules.

3. Power electronics component according to Claim 2, **characterized in that** the molecular sieve granules comprise zeolites with a crystalline lattice structure.

4. Power electronics component according to one of Claims 1 to 3, **characterized in that** the granules have an apparent density of approximately 0.7 kg/cm³.

5. Power electronics component according to one of Claims 1 to 4, **characterized in that** the granules (10) are moisture-absorbent.

6. Power electronics component according to one of Claims 1 to 5, **characterized in that** the housing (4) is provided with plastic covering plates.

7. Power electronics component according to one of Claims 1 to 6, **characterized in that** it is formed by a power capacitor or a phase module.

## Revendications

1. Composant d'électronique de puissance ayant une partie active électriquement qui est placée dans un boîtier (4), **caractérisé en ce qu'**un intervalle (9) entre la face extérieure de la partie active électriquement et la face intérieure du boîtier (4) est empli d'un granulé (10) minéral pouvant être mis en vrac.

2. Composant d'électronique de puissance suivant la revendication 1, **caractérisé en ce que** le granulé (10) est un granulé de tamis moléculaire.

3. Composant d'électronique de puissance suivant la revendication 2, **caractérisé en ce que** le granulé de tamis moléculaire est en zéolithe à structure de réseau cristalline.

4. Composant d'électronique de puissance suivant l'une des revendications 1 à 3, **caractérisé en ce que** le granulé a une masse volumique d'environ 0,7 kg/dm3.

5. Composant d'électronique de puissance suivant l'une des revendications 1 à 4, **caractérisé en ce que** le granulé (10) absorbe l'humidité.

6. Composant d'électronique de puissance suivant l'une des revendications 1 à 5, **caractérisé en ce que** le boîtier (4) est muni de plaques de recouvrement en matière plastique.

7. Composant d'électronique de puissance suivant l'une des revendications 1 à 6, **caractérisé en ce qu'**il est formé par un condensateur de puissance ou par un module de phase.
